# EUROPÄISCHE PATENTSCHRIFT

(11) **EP 1 405 407 B1**
(45) Veröffentlichungstag und Bekanntmachung des Hinweises auf die Patenterteilung: **28.09.2005**
(21) Anmeldenummer: 02754828.8
(22) Anmeldetag: 04.07.2002
(51) Int. Cl.: H03F 3/72

(54) **VERSTÄRKERUMSCHALTUNG**
AMPLIFIER SWITCH
COMMUTATEUR D'AMPLIFICATEUR

(30) Priorität: 12.07.2001 DE 10133862
(43) Veröffentlichungstag der Anmeldung: 07.04.2004
(73) Patentinhaber: Kathrein-Werke KG, 83022 Rosenheim (DE)
(72) Erfinder: HEROLD, Joachim, 83126 Flintsbach (DE)
(74) Vertreter: Flach, Dieter Rolf Paul
(86) Internationale Anmeldenummer: PCT/EP2002/007442
(87) Internationale Veröffentlichungsnummer: WO 2003/007473

(56) Entgegenhaltungen:
- EP-A- 0 964 511
- EP-A- 1 032 120
- GB-A- 2 334 168

## Beschreibung

Die Erfindung betrifft eine redundante Verstärkerumschaltung nach dem Oberbegriff des Anspruches 1.

Insbesondere in der Hochfrequenzverstärkertechnik ist es bekannt redundante Schaltungen zu verwenden.

Eine redundante Schaltungsanordnung gemäß dem Stand der Technik - wie er grundsätzlich aus der US-PS 5 418 490 A bekannt ist - umfasst eine zwischen einem Eingangs- und einem Ausgangstor vorgesehene Verstärkerschaltung. Diese Verstärkerschaltung weist zwei parallel geschaltete Verstärkerstufen auf, wobei beide Stufen eingangsseitig und ausgangsseitig mit einem Schalter, in der Regel einem Relaisschalter zu- und abschaltbar sind. Eine der beiden Verstärkerstufen ist über das eingangs- und ausgangsseitige Relais durchgeschaltet, wohingegen der Eingang und Ausgang der parallel angeordneten zweiten Verstärkerstufe abgeschaltet ist. Fällt die zugeschaltete Verstärkerstufe aus, werden die Kontakte des ein- und ausgangsseitigen Relais umgeschaltet auf den zweiten bisher nicht benötigten Verstärker. Sollte auch die zweite Verstärkerstufe ausfallen, so ist hinsichtlich des eingangs- und ausgangsseitigen Umschaltrelais zur Umschaltung zwischen den beiden Verstärkerstufen nochmals jeweils ein Relaisschalter in Reihe geschaltet, um in einem derartigen Fall eine zu den beiden Verstärkerstufen parallele Durchschaltstrecke unter Umgehung beider Verstärker durchzuschalten.

Grundsätzlich bekannt sind auch Ausführungsformen, bei welchen beide parallelen Verstärkerstufen kontinuierlich im Parallelbetrieb zusammengeschaltet sind. Fällt eine Verstärkerstufe aus, so bleibt aber doch zumindest die zweite Verstärkerstufe aktiv. Allerdings führt ein Ausfall einer Verstärkerstufe zu einer Verstärkungsabsenkung (beispielsweise um 4 bis 8 dB) und zu einer Rauschzahlerhöhung um beispielsweise 2 bis 4 dB. Zudem ist keine optimale Anpassung am Ein- und Ausgang gegeben. Dieser Betriebszustand muss von daher als verschlechterte Betriebsbedingung bezeichnet werden, der unbedingt eine Reparatur erforderlich macht. Ein weiteres Problem bei dieser Ausführungsform ist beispielsweise bei einer elektrischen Entladung (Blitzeinschlag etc.), dass in diesem Fall - da beide Verstärkerstufen grundsätzlich parallel in Betrieb sind - auch beide Verstärkerstufen ausfallen können.

Eine gattungsbildende zweistufige Verstärkerstufe ist aus der EP 1 032 120 A2 bekannt geworden. Es handelt sich um eine redundante Verstärkerstufe, bei welcher in Abhängigkeit einer jeweils gewünschten Verstärkung entweder beide Verstärker hintereinander oder nur jeweils einer der beiden Verstärker oder keiner der Verstärker betrieben werden sollen. Je nach Schaltungsteltung muss dabei zum Zeitpunkt der Umschaltung die Bypassleitung über einen zusätzlichen Schalter auf Masse gelegt werden. Ferner ist dazu notwendig, dass lediglich in der zweiten Bypassleitung ein Impedanz-Transformations-Kreis vorgesehen ist, dessen elektrische Länge einer Viertellänge entspricht.

Demgegenüber liegt der Erfindung die Aufgabe zugrunde, eine verbesserte redundante Verstärkerumschaltung zu schaffen. Insbesondere ist es Aufgabe der Erfindung, eine Verstärkerumschaltung zu schaffen, die vor allem eine niedrige Durchgangsdämpfung im Bypass-Modus und eine gute Anpassung im Verstärker-Modus aufweist.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Die Erfindung schafft mit verblüffend einfachen Mitteln deutliche Verbesserungen gegenüber dem Stand der Technik.

Die erfindungsgemäße Verstärkerumschaltung kann bereits bei zumindest zwei Verstärkungszweigen realisiert werden.

Die erfindungsgemäße redundante Verstärkerumschaltung ist dabei so aufgebaut, dass in einer Grundstellung jeweils nur eine Verstärkerschaltung und Verstärkerstufe zugeschaltet und in der zumindest einen vor- oder nachgeschalteten Verstärkerstufe durch Umschaltung des Schalters oder Relais die jeweilige Überbrückungsleitung zugeschaltet und damit der dortige Verstärker abgeschaltet ist. Fällt die aktivierte Verstärkerstufe aus, kann das Relais umschalten in die Überbrückungsstrecke, wobei das Relais oder der Schalter der weiteren Verstärkerstufe die Verbindung zur Überbrückungsleitung unterbricht und umschaltet zur Aktivierung der zugehörigen Verstärkerstufe. Dadurch liegen immer exakt die gleichen elektrischen Verhältnisse vor, so dass keine Dämpfungs- oder Anpassungs- oder sonstigen Probleme entstehen.

Die Überbrückungsstrecke, die von einem Schaltkontakt der Schaltereinrichtung zu einem Summierpunkt in der Verstärkerstrecke führt, ist nunmehr so bemessen, dass die elektrische Länge ca. λ/2 beträgt. Mit anderen Worten wird also der offene Relaiskontakt über die λ/2 lange Überbrückungsleitung hochohmig an das gegenüberliegende Tor transformiert, d.h. im Leerlauf betrieben.

Vor allem kann eine derartige redundante Schaltung mit zwei Verstärkerstufen mit nur zwei Schaltern auskommen, die wahlweise eingangs- oder ausgangsseitig bezogen auf die jeweilige Verstärkerstufe angeordnet sein können.

Gemäß einer bevorzugten Ausführungsform nach Anspruch 2 ist in der Verstärkerleitung zwischen dem Verstärker und dem Summierpunkt noch eine PIN-Diode geschaltet. Denn wenn die Verstärkerstufe nicht in Betrieb ist, würde eine Verbindung ohne PIN-Diode zu einer erhöhten Belastung in der Überbrückungs- und Durchgangsleitung führen. Durch die PIN-Diode kann die Verstärkerstufe hochohmig an die Leitung gekoppelt werden.

Die Erfindung wird nachfolgend anhand von Ausführungsbeispielen näher erläutert. Dabei zeigen im Einzelnen:
- Figur 1:: ein erstes schematisches Ausführungsbeispiel einer ersten VerstärkerschaltungsStufe, wie sie im Rahmen der anhand der Figuren 3 und 4 erläuterten erfindungsgemäßen redundanten Verstärkerumschaltung verwendet wird;
- Figur 2:: ein zu Figur 1 abgewandeltes Ausführungsbeispiel;
- Figur 3:: ein Ausführungsbeispiel einer redundanten Verstärkerschaltung mit zwei Verstärkerstufen in einem ersten Ausführungsbeispiel und
- Figur 4:: ein nochmals abgewandeltes Ausführungsbeispiel.

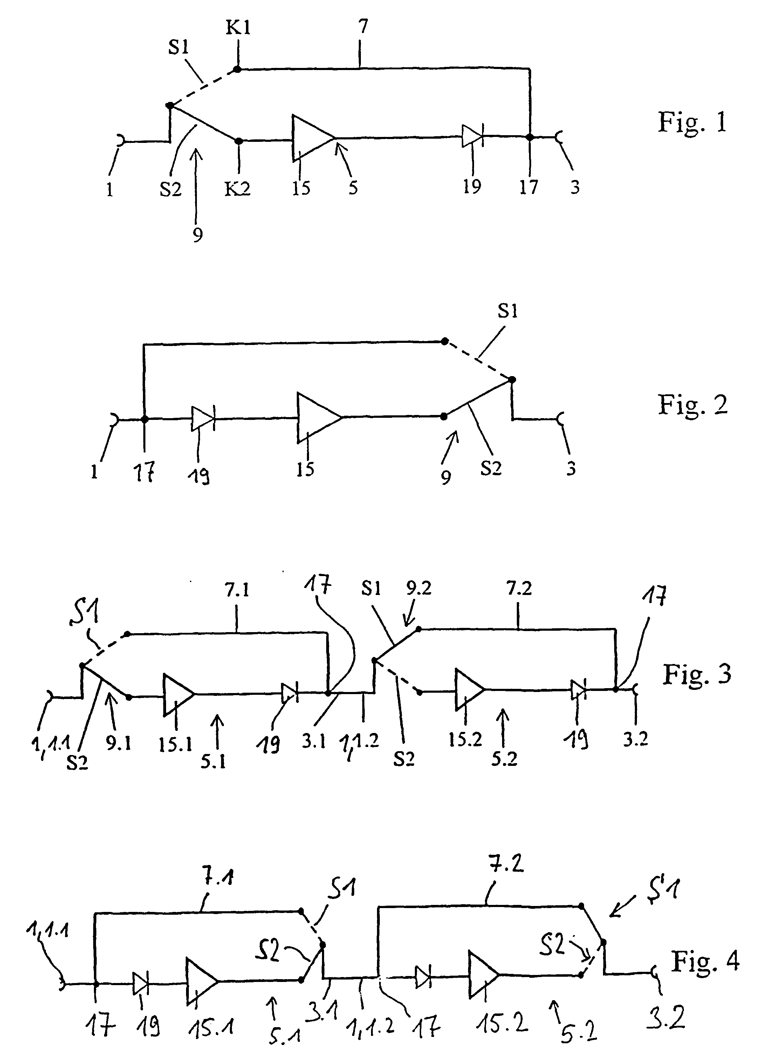

In Figur 1 ist ein erstes Ausführungsbeispiel einer Verstärkerumschaltung gezeigt, die zwischen einem Eingangstor 1 und einem Ausgangstor 3 vorgesehen ist, und die als eine Stufe einer anhand der Figuren 3 und 4 später erläuterten erfindungsgemäßen redundanten Verstärkerschaltung verwendet wird.

Die Schaltungseinrichtung umfasst zwei Zweige, nämlich einen Verstärkungszweig 5 und eine parallel dazu angeordnete Überbrückungsleitung 7.

Mit dem Eingangstor 1 in Verbindung steht ein Schalter 9, in der Regel ein Relais-Schalter 9, worüber eine Umschaltung vom Schalterkontakt K1 zum Schalterkontakt K2 vorgenommen werden kann. Befindet sich der Schalter im Schaltzustand S2 ist das Eingangstor 1 mit der Schalterkontakt K2 verbunden, wodurch die im Verstärkerzweig 5 geschaltete Verstärkungsschaltung 15 zugeschaltet ist.

Wird der eingangsseitige Schalter 9 umgeschaltet in den Schaltzustand S1, so wird die Verstärkerschaltung 15 abgeschaltet und die Überbrückungsleitung 7 über den Kontakt K1 mit dem Eingangstor 1 verbunden.

In der in Figur 1 gezeigten Schaltstellung S2 gelangt also die eingespeiste Leistung vom Eingangstor 1 an den Verstärker 15, wobei die Verstärkereingangsleistung über eine im Verstärkerzweig zwischen der Verstärkerschaltung 15 und dem Summierpunkt 17 zusätzlich vorgesehene niederohmige PIN-Diode 19 zum Ausgangstor 3 geführt wird. Die oben erläuterte Überbrückungsleitung 7, die in diesem Schaltzustand eine abgekoppelte Klemme K1 aufweist, ist nunmehr aber so dimensioniert, dass sie eine elektrische Länge aufweist, die ca. λ/2 entspricht. Dadurch wird der offene Relaiskontakt K1 nunmehr über diese λ/2 lange Leitung hochohmig an das Ausgangstor 3 transformiert. Dabei ist die Überbrückungsleitung 7 mit dem Verstärkerzweig 5 an einem Summierpunkt 17 zusammengeschaltet.

Das Ausführungsbeispiel gemäß Figur 2 unterscheidet sich von demjenigen nach Figur 1 dadurch, dass nunmehr kein eingangsseitiger Schalter 9, sondern ein ausgangsseitiger Schalter 19 vorgesehen ist, wobei ansonsten aber die elektrische Länge der Überbrückungsschaltung 15 ebenfalls wieder ca. λ/2 entspricht. In dieser Ausführungsform ist die Serien-PIN-Diode 19 am Eingang des Verstärkers 15, d.h. dem Verstärker 15 vorgeschaltet. Auch in diesem Fall entspricht die elektrische Länge der in Figur 2 gezeigten Überbrückungsleitung 7 (im abgekoppelten Zustand) etwa λ/2.

Anhand von Figur 3 wird nunmehr ein erstes Ausführungsbeispiel für eine redundante Verstärkerumschaltung beschrieben, bei der zwei Verstärkerumschaltungen gemäß Ausführungsbeispiel 1 in Reihe geschaltet sind.

In diesem Ausführungsbeispiel stellt also das Ausgangstor 3.1 der ersten Verstärkerumschaltungsstufe gleichzeitig das Eingangstor 1.2 der zweiten Verstärkerumschaltungsstufe dar. Jeder Verstärkerumschaltungsstufe ist dabei eine eingangsseitiger Schalter 9.1 bzw. 9.2 zugeordnet.

In der Grundstellung ist beispielsweise der erste eingangsseitige Schalter 9.1 in die Schaltstellung S2 geschaltet, bei welcher die vom Eingangstor 1 eingespeiste Leistung über den Verstärkungszweig 5.1 der nachgeschalteten PIN-Diode 13 der zweiten Verstärkerstufe 5.2 zugeführt wird, bei welcher der Schalter 9.2 sich in der Schaltstufe S1 befindet, also die von der ersten Verstärkerstufe kommende verstärkte Leistung über die Überbrückungsleitung 7.2 zum Ausgangstor 3.2 weiterleitet.

Ein Ausfall der ersten Verstärkerstufe 15.1 führt dazu, dass der erste Relaisschalter 9.1 in die Schaltstellung S1 umgeschaltet wird und dadurch die Verstärkerschaltung 15.1 durch Zuschaltung der zugehörigen Überbrückungsleitung 7.1 überbrückt wird. Gleichzeitig wird der Schalter 9.2 der zweiten Verstärkerstufe 15.2 von der Stellung S1 gemäß Figur 3 in Stellung S2 umgeschaltet, so dass nunmehr die zweite Verstärkerstufe 15.2 aktiviert wird.

Da die beiden Verstärkerstufen grundsätzlich gleich aufgebaut sind und dieselbe Funktionalität aufweisen (bzgl. Verstärkung, HF-Verhalten, Anpassung usw.), ergeben sich die gleichen elektrischen Verhältnisse wie vor der Umschaltung.

Eine Reparatur ist nicht dringend notwendig, sondern sollte nur in einem angemessenen Zeitraum vorgenommen werden, um möglichst sicherzustellen, dass nicht auch noch der zweite Verstärker ausfällt.

Diese Schaltungsanordnung hat auch den Vorteil, dass beispielsweise bei einer elektrischen Entladung (Blitzschlag) und einer dadurch bewirkten Zerstörung der ersten Verstärkerstufe 15.1 die zweite Verstärkerstufe 15.2 grundsatzlich geschützt ist, da sie abgekoppelt ist. Durch die Umschaltungen beider Relais-Schalter 9.1 und 9.2 kann also die intakte Verstärkerstufe 15.2 aktiviert werden.

Nur für den Fall, dass nach dem Ausfall der ersten Verstärkerstufe zum einem späteren Zeitpunkt vor Durchführung einer Reparatur auch die zweite Verstärkerstufe 15.2 ausfallt, würde dann auch der zweite Schaltkontakt 9.2 auch wieder so umschalten, dass auch die dort vorgesehene Überbrückungsleitung 7.2 aktiviert ist, so dass das Eingangstor 1.1 mit dem Ausgangstor 3.2 über die beiden hintereinander geschalteten Überbrückungsleitungen 7.1 und 7.2 verbunden ist.

## Patentansprüche

1. Redundante Verstärkerumschaltung mit den folgenden Merkmalen:
- mit zumindest zwei Verstärkungszweigen (5.1, 5.2)
- die zumindest zwei Verstärkungszweigen (5.1, 5.2) sind zwischen einem Eingangstor (1) und einem Ausgangstor (3) geschaltet,
- mit einer Schaltungsanordnung mit zugehörigen Schaltern (9.1, 9.2) derart, dass eine elektrische Verbindung zwischen dem Eingangstor (1) und dem Ausgangstor (3) über eine der mehreren Verstärkungszweigen (5.1, 5.2) oder über die Überbrückungsleitung (7.1., 7.2) herstellbar ist,
**gekennzeichnet durch** die folgenden weiteren Merkmale:
- die Verstärkungszweige (5.1, 5.2) sind in Reihe derart geschaltet, dass jeweils das Ausgangstor (3.1) eines Verstärkungszweiges (5.1) mit dem Eingangstor (1.1) eines nachfolgenden Verstärkungszweiges (5.2) elektrisch verbunden ist,
- parallel zu jedem Verstärkungszweig (5.1, 5.2) ist zwischen dem zugehörigen Eingangstor (1.1, 1.2) und dem zugehörigen Ausgangstor (3.1, 3.2) dieses Verstärkungszweiges (5.1, 5.2) eine zu- und abschaltbare Überbrückungsleitung (7.1, 7.2) vorgesehen.
- die Schaltungsanordnung zur Umschaltung der Übertragung von einem Verstärkungszweig (5.1, 5.2) auf einen anderen Verstärkungszweig (5.1, 5.2) oder auf die jeweils dazu parallelgeschalteten Überbrückungsleitung (7.1, 7.2) ist derart aufgebaut,
- dass zwischen dem Eingangstor (1.1, 1.2) und dem zugeordneten Verstärkungszweig (5.1, 5.2) sowie der zugehörigen Überbrückungsleitung (7.1, 7.2) ein Schalter (9.1, 9.2) vorgesehen ist, über welchen das Eingangstor (1.1, 1.2) entweder mit dem Verstärkungszweig (5.1, 5.2) oder der zugehörigen Überbrückungsleitung (7.1, 7.2) verbunden ist, und ausgangsseitig der Verstärkungszweig (5.1, 5.2) mit der zugehörigen Überbrückungsleitung (7.1, 7.2) über eine Summierschaltung oder einen Summierpunkt (17) verbunden ist, die bzw. der mit dem zugehörigen Ausgangstor (3.1, 3.2) des betreffenden Verstärkungszweiges in Verbindung steht, oder
- dass zwischen dem Ausgangstor (3.1, 3.2) und dem zugeordneten Verstärkungszweig (5.1, 5.2) sowie der zugehörigen Überbrückungsleitung (7.1, 7.2) ein Schalter (9.1, 9.2) vorgesehen ist, über welchen das Ausgangstor (3.1, 3.2) entweder mit dem Verstärkungszweig (5.1, 5.2) oder der zugehörigen Überbrückungsleitung (7.1, 7.2) verbunden ist und dabei eingangsseitig der Verstärkungszweig (5.1, 5.2) mit der zugehörigen Überbrückungsleitung (7.1, 7.2) über eine Summierschaltung oder einen Summierpunkt (17) verbunden ist, die bzw. der mit dem zugehörigen Eingangstor (1.1, 1.2) in Verbindung steht, und
- die jeweilige Überbrückungsleitung (7.1, 7.2) weist zwischen dem zugehörigen Schaltkontakt (K1) des zugehörigen Schalters (9.1, 9.2) und der jeweils zugeordneten Summierschaltung bzw. dem jeweils zugeordneten Summierpunkt (17) eine elektrischen Länge auf, die ca. λ/2 entspricht.

2. Redundante Verstärkerumschaltung nach Anspruch 1, **dadurch gekennzeichnet, dass** zwischen der jeweiligen Verstärkerschaltung (15) und einem betreffenden Verstärkungszweig (5.1, 5.2) und der jeweiligen zugeordneten Summierschaltung bzw. dem zugeordneten Summierpunkt (17) eine PIN-Diode (19) geschaltet ist.

3. Redundante Verstärkerumschaltung nach Anspruch 1 oder 2, **dadurch gekennzeichnet, dass** die Schalter (9.1, 9.2) aus Relais-Schaltern gebildet sind, vorzugsweise aus Relais-Schaltern mit niedriger Durchgangsdämpfung.

## Claims

1. Redundant amplifier switch having the following features:
- having at least two amplifier branches (5.1, 5.2)
- the at least two amplifier branches (5.1, 5.2) are connected between an input gate (1) and an output gate (3),
- having a circuit arrangement with associated switches (9.1, 9.2), such that an electrical connection can be made between the input gate (1) and the output gate (3) via one or more amplifier branches (5.1, 5.2) or via the bridging line (7.1, 7.2),
**characterized by** the following further features:
- the amplifier branches (5.1, 5.2) are connected in series in such a way that the output gate (3.1) of one amplifier branch (5.1) is in each case electrically connected to the input gate (1.1) of a downstream amplifier branch (5.2),
- a bridging line (7.1, 7.2), which can be connected and disconnected, is provided in parallel with each amplifier branch (5.1, 5.2) between the associated input gate (1.1, 1.2) and the associated output gate (3.1, 3.2),
- the circuit arrangement for switching the transmission from one amplifier branch (5.1, 5.2) to another amplifier branch (5.1, 5.2) or to the bridging line (7.1, 7.2) which is in each case connected in parallel with it is designed such
- that a switch (9.1, 9.2) via which the input gate (1.1, 1.2) is connected either to the amplifier branch (5.1, 5.2) or the associated bridging line (7.1, 7.2) is provided between the input gate (1.1, 1.2) and the associated amplifier branch (5.1, 5.2) and the associated bridging line (7.1, 7.2), and the amplifier branch (5.1, 5.2) is connected at the output end to the associated bridging line (7.1, 7.2) via a summing circuit or a summing point respectively (17) which is connected to the associated output gate (3.1, 3.2) of the relevant amplifier branch, or
- that a switch (9.1, 9.2) via which the output gate (3.1, 3.2) is connected either to the amplifier branch (5.1, 5.2) or the associated bridging line (7.1, 7.2) is provided between the output gate (3.1, 3.2) and the associated amplifier branch (5.1, 5.2) and the associated bridging line (7.1, 7.2), and in this case the amplifier branch (5.1, 5.2) is connected at the input end to the associated bridging line (7.1, 7.2) via a summing circuit or a summing point (17) which is connected to the associated input gate (1.1, 1.2), and
- the respective bridging line (7.1, 7.2) has, between the associated switching contact (K1) of the associated switch (9.1, 9.2) and the respectively associated summing circuit or the respectively associated summing point (17) an electrical length which corresponds to approximately λ/2.

2. Redundant amplifier switch according to Claim 1, **characterized in that** a PIN diode (19) is connected between the respective amplifier circuit (15) and a relevant amplifier branch (5.1, 5.2) and the respectively associated summing circuit or the associated summing point (17).

3. Redundant amplifier switch according to Claim 1 or 2, **characterized in that** the switches (9.1, 9.2) are formed from relay switches, preferably from relay switches with a low throughput attenuation.

## Revendications

1. Circuit amplificateur redondant, présentant les éléments suivants :
- il est prévu au moins deux branches d'amplification (5.1, 5.2),
- lesdites au moins deux branches d'amplification (5.1, 5.2) sont branchées entre une porte d'entrée (1) et une porte de sortie (3),
- il est prévu un agencement de circuit avec des commutateurs associés (9.1, 9.2) de telle sorte qu'une connexion électrique entre la porte d'entrée (1) et la porte de sortie (3) peut être établie par l'une des plusieurs branches d'amplification (5.1, 5.2) ou par la ligne de pontage (7.1, 7.2),
**caractérisé par** les autres éléments suivants :
- les branches d'amplification (5.1, 5.2) sont branchées en série de telle sorte que chaque porte de sortie (3.1) d'une branche d'amplification (5.1) est connectée électriquement à la porte d'entrée (1.1) d'une branche d'amplification successive (5.2),
- parallèlement à chaque branche d'amplification (5.1, 5.2) est prévu une ligne de pontage (7.1, 7.2) susceptible être mise en circuit et d'être coupée entre la porte d'entrée associée (1.1, 1.2) et la porte de sortie associée (3.1, 3.2) de cette branche d'amplification (5.1, 5.2),
- l'agencement de circuit pour commuter la transmission d'une branche d'amplification (5.1, 5.2) vers une autre branche d'amplification (5.1, 5.2) ou vers la ligne de pontage respective (7.1, 7.2) branchée en parallèle est conçu de telle sorte que
-- entre la porte d'entrée (1.1, 1.2) et la branche d'amplification associée (5.1, 5.2) ainsi que la ligne de pontage associée (7.1, 7.2), il est prévu un commutateur (9.1, 9.2) par lequel la porte d'entrée (1.1, 1.2) est connectée soit à la branche d'amplification (5.1, 5.2) soit à la ligne de pontage associée (7.1, 7.2), et du côté sortie la branche d'amplification (5.1, 5.2) est connectée à la ligne de pontage associée (7.1, 7.2) via un circuit de sommation ou via un point de sommation (17) qui est en connexion avec la porte de sortie associée (3.1, 3.2) de la branche d'amplification concernée, ou
-- entre la porte de sortie (3.1, 3.2) et la branche d'amplification associée (5.1, 5.2) ainsi que la ligne de pontage associée (7.1, 7.2), il est prévu un commutateur (9.1, 9.2) par lequel la porte de sortie (3.1, 3.2) est connectée soit à la branche d'amplification (5.1, 5.2) soit à la ligne de pontage associée (7.1, 7.2), et du côté entrée la branche d'amplification (5.1, 5.2) est connectée à la ligne de pontage associée (7.1, 7.2) via un circuit de sommation ou via un point de sommation (17) qui est en connexion avec la porte d'entrée associée (1.1, 1.2), et - la ligne de pontage respective (7.1, 7.2) comprend entre le contact de commutation associé (K1) du commutateur associé (9.1, 9.2) et le circuit de sommation respectif associé ou le point de sommation respectif associé (17) une longueur électrique qui correspond à environ λ/2.

2. Circuit amplificateur redondant selon la revendication 1, **caractérisé en ce qu'**une diode PIN (19) est branchée entre le circuit amplificateur respectif (15) et une branche d'amplification concernée (5.1, 5.2) et le circuit de sommation respectif associé ou le point de sommation associé (17).

3. Circuit amplificateur redondant selon l'une ou l'autre des revendications 1 et 2, **caractérisé en ce que** les commutateurs (9.1, 9.2) sont formés par des commutateurs à relais, de préférence par des commutateurs à relais à faible amortissement de transmission.
